# EUROPEAN PATENT SPECIFICATION

(11) **EP 1 315 200 B1**
(45) Date of publication and mention of the grant of the patent: **09.07.2008**
(21) Application number: 01204564.7
(22) Date of filing: 26.11.2001
(51) Int. Cl.: H01L 21/28, H01L 21/3215, H01L 21/8238, H01L 21/3213

(54) **Methods for CMOS semiconductor devices with selectable gate thicknesses**
Herstellungsverfahren für CMOS-Halbleiter-Bauelemente mit wählbaren Gatedicken
Procédés des fabrication de dispositifs semiconducteurs CMOS avec des épaisseurs de grilles sélectionnables

(43) Date of publication of application: 28.05.2003
(73) Proprietor: INTERUNIVERSITAIR MICROELEKTRONICA CENTRUM VZW, 3001 Heverlee (BE)
(72) Inventor: Jurczak, Malgorzata, 3000 Leuven (BE); Augendre, Emmanuel, 3001 Leuven (BE); Rooyackers, Rita, 3010 Leuven (BE); Badenes, Goncal, 08206 Sabadell (ES)
(74) Representative: Bird, William Edward

(56) References cited:
- GB-A- 2 346 261
- US-A- 4 057 895
- US-A- 5 021 354
- US-B1- 6 171 897
- US-B1- 6 294 460
- PATENT ABSTRACTS OF JAPAN vol. 2000, no. 05, 14 September 2000 (2000-09-14) & JP 2000 058668 A (SHARP CORP), 25 February 2000 (2000-02-25)

## Description

### Field of the invention

The present invention relates to semiconductor processes in which structural elements formed in a common layer need to have a different thickness. Particularly in submicron CMOS technologies the thickness of the gate electrode of a nMOS device needs to differ from the gate electrode thickness of the pMOS devices. Hence, the present invention also relates to methods for manufacturing CMOS semiconductor devices with selectable gate thickness.

### Background of the invention/State of the Art

By definition CMOS integrated circuits combine both n-type (nMOS) and p-type (pMOS) field effect transistors (FET). These two type of transistors are also commonly referred to as n-channel or nMOS and p-channel or pMOS devices respectively. Methods to fabricate such CMOS circuits are know in the art. On a semiconductor substrate, such as silicon, areas are selected on which these transistors will be formed during subsequent processing. These so-called "active areas" are insulated from each other by forming insulation structures in between. Examples of such insulation structures are locally oxidized silicon (LOCOS) or shallow trenches filled with dielectrics (STI). Active areas where later on nMOS or pMOS devices will be formed, can be labelled respectively as nMOS or pMOS active areas.. A gate dielectric is formed on the surface of the semiconductor substrate. Typically the gate dielectric is formed by oxidizing the silicon surface or by forming a stack comprising high-k dielectrics on the substrate. On top of this gate dielectric a gate electrode is established. Typically the gate electrode is obtained by depositing a semiconducting material such as polysilicon (pSi) or polysilicongermanium (pSiGe) or alloys thereof. This layered gate dielectric and electrode material is then patterned to yield the gate stack of the individual transistors. The semiconductive gate electrode material is rendered conductive by doping it with dopants normally provided by an ion implantation source. Although the gate electrode material is common to both nMOS and pMOS devices, the doping of the gate electrode of both devices is done seperately by selectively masking regions comprising only one of both device types. During the doping of the gate electrode of the nMOS transistor also the source/drain junctions of the NMOS may be formed and, mutatis mutandis, during the doping of the pMOS transistor the corresponding source/drain junctions may be formed in the non-masked active areas. The source/drain junctions serve as electrical contacts to the oppositely doped channel region, formed underneath the gate stack. Addional implantations can be done in the course of the process flow e.g. to form doped regions in the substrate such as a well or sink, or other implantations known to a person skilled in the art and required to obtain the desired electrical and functional behaviour of the device to be processed

The doping of the gate electrode has to meet several requirements. The ion implant dose (ions/cm²), used to simultaneously dope the gate electrode and the junction regions, must, for example, be high enough to obtain a sufficiently low resistivity in both the gate electrode and the source/drain junctions. The doping should ideally be uniform over the gate electrode, certainly down to the interface with the underlying gate electrode. If the doping concentration (ions/cm³) at the gate dielectric/gate electrode interface is too low, this part of the gate electrode can be depleted if the field effect transistor is biased into inversion. Such unwanted depletion will have a negative impact on the electrical performance of the transistor: the depletion layer forms an additional capacitance in series with the gate capacitance and it diminishes the control of the gate voltage over the channel and bulk region leading to more severe short channel effects. If a high implant energy is used to implant the ions into the gate electrode then such uniformly doped gate electrode layer could be obtained. This implant energy however has to be within certain limits because the doping of the gate electrode must be confined to the gate electrode itself. If the gate dopants would reach the oppositely doped channel region, the channel can be counterdoped or at least the effective channel doping is reduced leading to a change in the threshold voltage and the "short channel"-characteristics of the device. A high implant energy would also result in deep junctions whereas in submicron CMOS-based technologies shallow junctions are preferred because of the decreased short channel effects and junction capacitance. On the other hand, if a low implant energy is used followed by thermal processing steps, the above problems can be avoided, but during these, or other subsequent, thermal processing steps the gate dopants might diffuse from the gate electrode through the gate dielectric into the channel region and compensate the channel doping.

Because ions, such as P, As or Sb, are used to dope the gate electrode of an nMOS device the penetration of the channel region during implantation of such heavy ions is unlikely to happen even at elevated implant energies. As the diffusion speed of these impurities, at least in the gate dielectric, is low the channel region will essentially not be penetrated by these heavy ions during thermal processing steps following the implantation step. On the other hand the lighter ions, such as B, used to dope the gate electrode of a pMOS devices are more likely to penetrate the channel through the thin gate dielectrics used in submicron MOS technologies. If the annealing conditions are optimized for pMOS transistors to avoid extensive boron penetration in the channel region, high gate depletion in NMOS device might occur as the thermal energy or budget of the CMOS process is not sufficient to activate the n-type dopants or have them diffuse all over the gate electrode. The integration of both devices requires therefore very careful optimization of implantation conditions and final annealing step.

The Japanese patent application JP2000058668 corresponding to the preamble of claim 1 proposes an CMOS architecture having two thicknesses of the polysilicon gate electrode. The thinner nMOS gate electrode requires less diffusion of the n-type dopants and hence less thermal energy is required to obtain a uniform doping of this gate electrode. The thicker pMOS gate electrode offers enough stopping capability to the implanted ions to prevent penetration of the channel. Thicker pMOS gate electrode enables an increase of the temperature of final RTA and thus improve the dopant activation, without the risk of boron penetration. For a given thermal budget the p-type impurities must diffuse a larger distance before they reach the gate electrode/gate dielectric interface or even the channel region. This so-called "dual gate" CMOS process facilitates the optimization of the process of the gate electrodes with respect to reduction of gate depletion in nMOS and boron penetration in the channel for the pMOS devices. The patent discloses several embodiments describing methods to decrease the thickness of the gate electrode for the nMOS devices or to increase the thickness of this gate electrode layer for the pMOS devices:
1. mask the as-deposited polysilicon layer outside the regions of the nMOS devices, remove the polysilicon layer in these unmasked regions using a timed etching, e.g a dry etching technique such as Reactive Ion Etching (RIE) during a predetermined periode of time
2. deposite a multilayer structure of polysilicon/silicon oxide/polysilicon as gate electrode on the gate dielectric and remove the top polysilicon layer of this multilayer only in the regions where the nMOS devices will be formed
3. mask the as-deposited polysilicon gate electrode layer outside the region of the pMOS devices by a thin oxide layer and grow an additional silicon layer on the top the non-oxidized regions of the as-deposited polysilicon layer
4. mask the as-deposited polysilicon gate electrode layer in the area of the pMOS devices by a thin nitride layer, oxide the non-masked polysilicon layer and remove the oxidised polysilicon layer by a wet etch process

The proposed method sequences have several disadvantages with respect to process complexity and manufacturability. Additional topography is created between the nMOS and pMOS devices as the variation in thickness of the as-deposited polysilicon electrode is obtained prior to the patterning of this polysilicon layer. This difference in height influences the process latitude and control of the patterning process. During the step of etching the polysilicon layer the gate stack of the nMOS device might be overetched resulting in attacking the underlying active area. This problem of "pitting" might be of more concern in case the electrode etching has to stop on thin gate dielectrics. The proposed sequences are therefore not suitable for use in scaled down CMOS processes.

If a dry etch technique is used to thin the as-deposited polysilicon layer in the nMOS regions the underlying gate oxide is exposed to this etching plasma and plasma damage of the gate dielectric might occur. Timed etch processes are known to result in high dispersion of the final thickness as no control over the etching parameters such as etch speed is performed. Thickening the as-deposited polysilicon layer in the region of the pMOS devices certainly adds to process complexity as masking steps have to be used as well as processes capable of selective growth. Selective growth or selective etching requires the presence of a masking or stopping layer. If this masking or stopping layer is not removed it will influence the electrical performance of the gate electrode and hence of the corresponding device.

### Aims of the invention

An aim of the present invention according to the claims is to adjust locally the thickness of a layer used in a semiconductor process in a cost-effective way, with improved uniformity and repeatability.

Another aim of the present invention is to adjust locally the thickness of a layer used in a semiconductor process with a limited number of process steps.

Another aim of the present invention is to tune the thickness of groups of features formed in a common layer to a desired thickness in a cost-effective and efficient way.

Another aim of the present invention is to obtain a CMOS circuit in which the thickness of the common gate electrode depends on the MOS device, e.g. an n-type or a p-type device.

Another aim of the present invention is to obtain a CMOS circuit in which the thickness of the common gate electrode is locally adjusted with a limited number of process steps.

Another aim of the present invention is to obtain a CMOS circuit in which the thickness of the common gate electrode is locally adjusted thereby at least preserving the performance of the CMOS devices and the control over the gate linewidth.

Another aim of the present invention is to disclose a method to compensate for the difference in diffusion speed between different types of gate electrode dopants used in a CMOS process.

Another aim of the present invention is to yield devices comprising three-dimensional structures formed in a common device material whereby the formation of said three-dimensional structures only requires one additional masking step.

Another aim of the present invention is to offer an additional degree of freedom in optimizing the thermal budget of a CMOS process for both n-type and p-type devices.

Another aim of the present invention is to disclose a method to compensate for the difference in ion implant energy range between different types of gate electrode dopants, applicable in a submicron CMOS process.

Another aim of the present invention is to obtain a CMOS circuit comprising field effect transistors with a minimal junction depth and a gate electrode doped substantially uniform over and confined to the gate electrode layer.

### Summary of the invention

In a first aspect of the invention according to the claims a method is disclosed to create topography in a device layer of an electronic component such as an integrated circuit or a device created by methods used in manufacture of electronic components, e.g. a MEMS device. This method comprises the steps of: providing a substrate, forming a device layer on said substrate, creating in selected regions of said device layer a disposable part, patterning said device layer, at least in said selected regions, and selectively removing said disposable part of said device layer. The disposable part is formed within the thickness of the device layer but not completely through this layer. Preferably this disposable part is created by changing the removal properties of said device layer up to a predetermined depth. More preferably this change in removal properties of the device layer is due to or related to the introduction of a chemical material into the device layer, e.g. by doping these selected regions up to a predetermined depth.

The present invention can provide an integrated circuit, comprising at least a first and second region of a device layer, said first region having a different thickness from said second region, characterized in that: said difference in thickness between the first and second region results from removing a disposable part created in said device layer after the device are patterned to form the first and second regions.

The present invention can also provide a partially completed integrated circuit, comprising at least a first and second region of a device layer, said first and second region having a first thickness, characterized in that: at least within the thickness of the first region a disposable portion is provided such that the disposable part is removable to thus form said first region with a different thickness from said second region.

In yet another aspect of the invention a CMOS process is disclosed in which the thickness of gate electrode depends on the type of transistor. In this embodiment the substrate is semiconductor substrate, whereas the device layer is the gate electrode layer. Preferably an antireflecting layer is deposited on top of the device layer. Disposable elements are created in the device layer, whereafter the device layer is patterned. The disposable elements are then removed using an etchant that also removes this antireflecting layer if present.

The present invention will now be described with reference to the following drawings.

### Description of the drawings

All drawings are intended to illustrate some aspects and embodiments of the present invention and are not made to scale. Devices and fabrication steps are depicted in a simplified way for reason of clarity. Not all alternatives and options are shown and therefore the invention is not limited to the content of the given drawings.
Figure 1a-f: a schematic description of a process flow according to a first embodiment of the invention illustrating by means of cross sectional drawings the steps of forming devices with varying thickness within the same layer
Figure 2a-d: a schematic description of a process flow according to a second embodiment of the invention illustrating by means of cross sectional drawings the steps of forming nMOS and pMOS devices with different gate electrode thickness
Figure 3 a SEM top view picture illustrating the thickness uniformity and linewidth controll after forming the height difference within the electrode layer according to a second embodiment
Figure 4a-b: a SEM top view picture illustrating CMOS devices comprising n-type and p-type active areas illustrating the thickness uniformity and linewidth controll after forming the height difference within the electrode layer according to a preferred embodiment
Figure 5a-e: a schematic description of a process flow according to a preferred embodiment of the invention illustrating by means of cross sectional drawings the steps of forming nMOS and pMOS devices with different gate electrode thickness
Figure 6a-e: a schematic description of a process flow according to an embodiment of the invention illustrating by means of cross sectional drawings the steps of forming a MEMS device

### Detailed description of the illustrative embodiments

In relation to the appended drawings the present invention is described in detail in the sequel. It is apparent however that a person skilled in the art can imagine several other equivalent embodiments, the scope of the present invention being limited only by the terms of the appended claims. The present invention will mainly be described with reference to forming disposable layers within the thickness of a device layer. The device layer may be part of an electronic device such as an integrated circuit or a device manufactured by techniques used for electronic component processing, e.g. a MEMS device.

In semiconductor processing it is often desirable to have devices available with different thickness or layer height. As explained above, forming nMOS and pMOS devices with different gate electrode thickness can be of assistance e.g. in suppressing short channel effects. Also resistors or capacitors with different electrode thickness could be formed, resulting in different electrical characteristics, e.g. as the resistance of such device, or in processing characteristics, e.g. topographical variations. Preferably, these devices are formed within a common layer of device material, as this would save on production costs. As only one layer of such device material has to be formed on the substrate to finally yield devices with different thickness, the process throughput will be improved. After forming this device layer the thickness of the device layer will be adjusted or modulated to yield devices or parts thereof with different heights to meet the different device or process requirements. A device layer is a stack of at least one layer formed on a substrate which may be a semiconductor substrate and of which at least parts thereof remain present in the finished device. The device layer can also be referred to as a permanent layer. A device material is a material that constitutes elements or parts of the finished device.

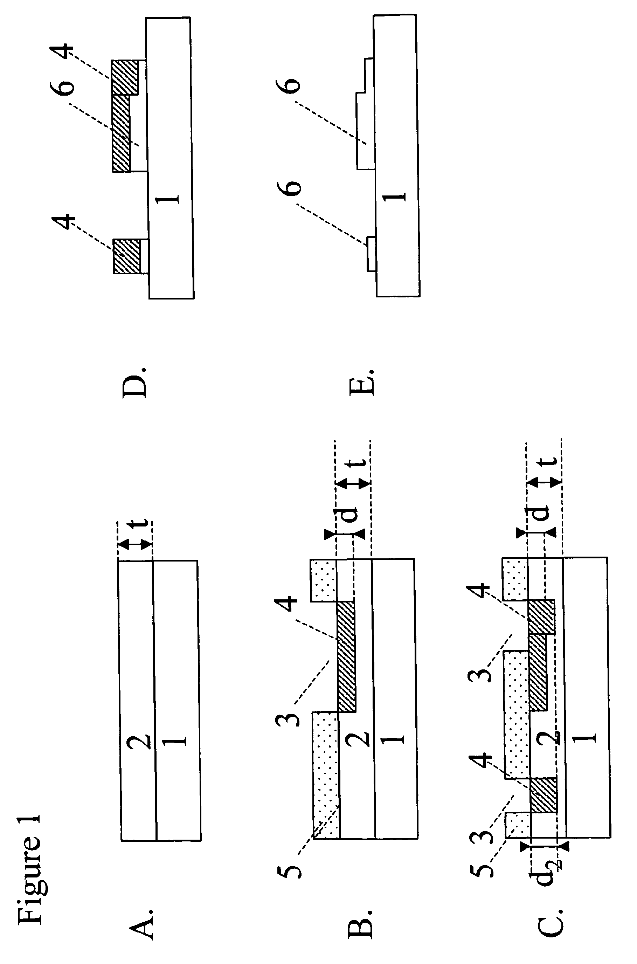

A first embodiment of the invention is illustrated in figures 1a-e. A device layer (2), with an as-deposited thickness t is formed on a substrate (1), as shown in figure 1a . This substrate (1) can be at least a part of a partly processed or a pristine wafer or slice of a semiconductor material, such as Si, GaAs, Ge, SiGe, or a insulating material, such as a glass slice, ceramic materials, sapphire, or a conductive material, such as metal. The substrate can have a flat surface are can already have topography, but this topography is not shown in the figures 1a-e. In case of e.g. a silicon wafer used in CMOS processing this topography can result from the formation of active areas where the silicon surface is exposed and field regions where an insulating layer such as silicon dioxide layer is formed. The device layer (2) can be of any material, used in semiconductor processing: insulating material such as oxides or nitrides, semiconducting material such as Si, SiGe, GaAs, Ge or a conductive material such as a metal, e.g. Ti, W. The device layer (2) can be formed by chemical vapor deposition (CVD) techniques, spin-coating or other techniques applicable in the state-of-the art. The device layer (2) can be a stack of layers, e.g. Si formed on SiGe.

In selected regions (3) disposable (removable or sacrificial) parts, partitions or members (4) are formed in this device layer (2). Regions can be selected by applying e.g. photolithographic processes know in the art whereby a photosensitive resin or resist (5) is spun on the substrate (1). This photosensitive resin will be selectively exposed to a form of radiation outlining the selected regions. After subsequently developing the exposed regions (3) of the photosensitive resin, the patterned photosensitive resin will cover the underlying layers in those areas where the resin remained. Locations (3) from which the resist is removed and hence become unmasked, can be subjected to a variety of subtractive, e.g. dry or wet etching, or additive, e.g. ion implanting, processes. A disposable part (4) can be formed in this device layer (2) by making this device layer disposable, at least up to a predetermined depth d, in the unmasked regions (3), i.e. the selected regions (3) as shown in figure 1b. Disposable parts are formed by exposing the device layer (2) within the selected regions (3) to an external environment or species capable of differentiating the material properties, more specific the removal, for example, the degradation or erosion properties of the device layer (2) within selected regions (3) from the material properties of this device layer (2) in the non-selected regions or in the unaffected parts of the selected regions. Thus by locally changing the removal properties of said device layer (2) untill a predetermined depth d a disposable part of said device layer is formed. This alteration of the material properties need not essentially affect the as-deposited thickness t of the device layer.

This sequence of selecting regions and forming disposable parts in this device layer (2) at these selected regions (3) can be repeated as many times as necessary. In each such sequence different regions and/or different predetermined depths d can be selected allowing the height of the disposable parts formed in this device layer to vary from one selected region to another as shown in figure 1c. The initial depth of the disposable part (4) formed in region (3) as selected in figure 1b is locally increased in the newly selected regions (3) from a value d to a value d₂ while in another newly selected region (3) a disposable part (4) with the same dept d₂ is created.

After forming the disposable members (4), the device layer (2) is patterned as illustrated in figure 1d and 1e. Using standard processing two-dimensional devices or geometrical features are established in the device layer both in the selected regions (3) as in the non-selected regions. Whereas in a previous step the height profile of the final devices is predetermined by varying the removal properties of the device layer, this patterning step defines the layout of the devices. The formation of such two-dimensional devices can be done, e.g. by patterning steps know in the art. Such a patterning step can comprise the step of transferring, by means of a photolithographic process, the desired pattern from a photomask to a resist layer (5) covering the device layer as shown in figure 1d. The resist layer (5) covers parts of the disposable elements (4,4) or parts of device layer that doesn't contain disposable elements. The thus formed resist pattern is then transferred to the underlying device layer by a variety of subtractive processes. The patterning process can also comprise the step of removing or stripping the protective resist pattern, yielding a variety of two-dimensional devices or geometrical features formed within the same layer, these two-dimensional devices comprising disposable parts (4), these disposable parts having the same or different thickness as shown in figure 1e. Figures 1e illustrates the case wherein 3 devices are formed within the device layer (2). The left device is patterned within the perimeter of the corresponding selected region (3) creating a stack partitioned in a disposable element (4) and a non-disposable element. The device in the middle is patterned outside any selected region (3) and doesn't comprise any disposable or sacrificial part. The thickness of this genuine device is the thickness of the device layer. The device on the right has 3 partitions as it overlaps partly two selected regions (3, 3) and one non-selected region. The device on the right thus contains a disposable part (4") on the left with thickness d, a disposable part in the middle (4) with thickness d₂ and a non-disposable part (6) having the thickness t of the device layer. As at this stage of processing which deals with the geometrical patterning of the device layer, the as-deposited thickness t of this device layer is substantially maintained, the patterning process can be very well controlled and will not suffer e.g. from focusing problems or difference in heigth of the layer to be etched.

After the patterning of the device layer (2) the disposable parts (4) of the patterned device layer are removed, selectively with respect to the substrate (1) and to the non-disposable parts (6) of the patterned device layer, yielding a variety of devices formed within the same device layer as shown in figure 1f. The difference in material properties, e.g. removability or solubility, previously introduced in the device layer is thus exploited to remove the disposable parts (4) of the patterned device layer at least selective to the other parts (6) of this device layer. This removal can be done by dry, e.g. reactive ion etching (RIE) or wet etching or by any other suitable removal process. The thickness of the non-removed parts or members of the patterned device layer (2) can vary from one device to another or can vary within one device. The disposable parts can be removed selectively because the removal properties of these disposable parts are enhanced with respect to the other parts of this device layer. Depending on the depth to which these removal properties of the device layer are changed, disposable parts with different heights are or can be formed. The local layer thickness of a device or part thereof will be the as-deposited thickness t of the device layer minus the local predetermined depth d to which the disposable part is formed. During the step of removing the disposable part, the feature size of the device, as defined during the preceding patterning step, is substantially maintained. Figure 1f shows the patterned devices of figure 1e after the disposable elements are removed. The device (6) on the left has a reduced thickness, the device in the middle (6) is not affected by the removal of the disposable elements, while the device (6) on the right has topography.

As that part of the device layer (2) in which the material properties are changed, i.e. the disposable part (4), is removed and hence is no langer present in the resulting devices, the electrical or physical behaviour of these devices is not impaired by the process of locally modifying the thickness of the device layer. The properties of the non-disposable parts (6) of the device layer are essentially unaffected in the present method and are substantially identical to the properties of the as-deposited device layer.

In a second embodiment of the invention a method is disclosed to form a dual-thickness gate electrode. A CMOS circuit is formed comprising nMOS and pMOS devices. The nMOS devices preferably have a gate electrode smaller in height then the pMOS devices. The gate electrode of both devices is made of a common material. Such dual-thickness gate electrode offers a wide technological window and process margin for optimization of the gate stack in a CMOS process integration flow. The variation in thickness of the material, used to form the gate electrode, is made after the patterning of the individual gate stacks. This process sequence simplifies the patterning process as during the lithographic step no additional topography is introduced which might require adaption of the lithographic processing. During the etching step the risk of damaging the gate dielectric or other side effects e.g. pitting or consuming the substrate next to the gate stack, is considerably reduced. The proposed method of gate thinning is a self stopping process thanks to the selectivity built in in the gate electrode material. This selectivity is only exploited after the patterning process. The proposed process sequence therefore gives much better uniformity and repeatability than known in the prior art.

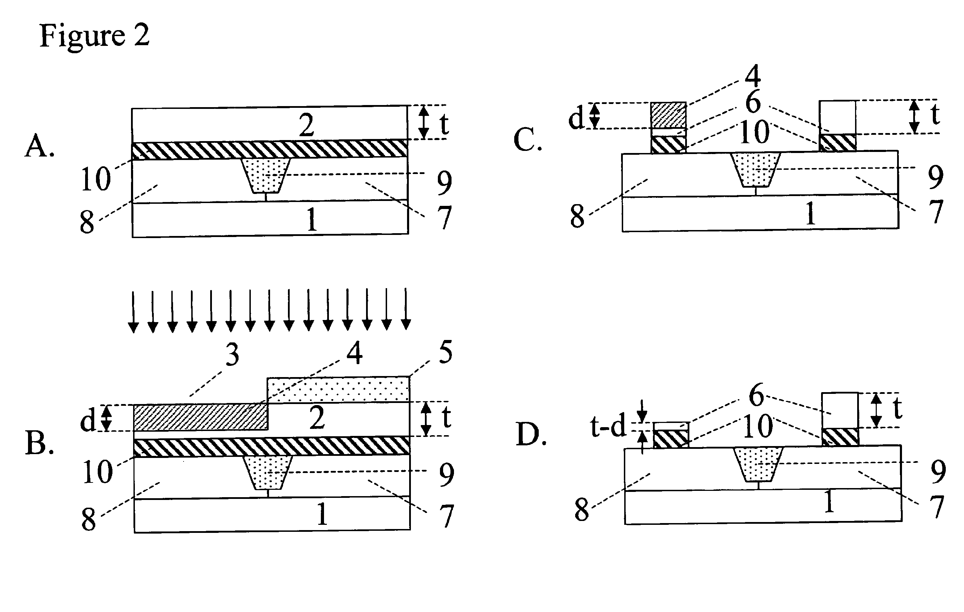

The formation of the gate stack in the CMOS process according to the present invention is illustrated in figure 2. A substrate (1) is provided, for example a semiconductor substrate (1) comprising semiconductor topography is provided. Upon a first region, e.g. a p-type active area (7), a first gate stack comprising an insulator (10) and conductor (2), is formed. Upon a second region, e.g. a n-type active area (8), a second gate stack is formed. The first (7) and second regions (8) can be laterally spaced apart e.g. by field regions (9). Both first and second gate stack comprise a gate dielectric (10) and a gate electrode material (2), as shown in figure 2a. The gate dielectric (10) can be silicon dioxide, silicon nitride or other dielectrics used in semiconductor processing. The thickness of the gate dielectric layer may vary from 0.1nm to 50nm, preferably from 1 to 10nm. The gate electrode material (2) can be e.g. Si, SiGe in various degrees of crystallinity such as amorphous, polycrystalline, monocrystalline. The as-deposited thickness t of the gate electrode material can range from 10 to 500nm, preferably from 50 to 350nm. Some active areas (7) will be used to form pMOS devices upon, while the other active areas (8) will be used to form nMOS devices upon.

Selected regions (3) of the gate electrode material, which is the device layer (2) of the first embodiment, are doped to form the disposable parts (4) as shown in figure 2b. The regions are selected by a photolithographic process using e.g. the so-called nPLUS mask. The pattern of this nPLUS mask defines the regions where later on in the process flow the junction implant of the nMOS devices will be made, while the remaining area of the substrate, including the pMOS active area (7), remains covered with resist (5). This nPLUS mask is already available in a standard CMOS maskset. Other masks, e.g. the p WELL mask, or more dedicated masks may be used depending on the specific configuration of the circuit composed of the individual devices being processed.. Preferably the doping of the selected regions (3) is done by ion implantating, as indicated by the arrows in figure 2b, but doping from a gaseous environment or solid source is also feasible. Ion implantant doping has the advantages of controlling the doping levels over many orders of magnitude and establishing the depth profiles of the implanted species by controlling energy effects and channeling effects. Depending on the implantation energy and the type of species the implant depth d can be varied. In the example of polysilicon as gate electrode layer (2) implantation species can be P, As, B, Sb, N, O, Ge while the implantation energy can range from 100eV to 200keV depending on the as-deposited thickness t and on the requested remaining thickness of the final gate electrode, which equals t-d. The implant dose can range from 1e14 at/cm² to 1e20 at/cm², preferably from 1e15at/cm² to 1e17at/cm². After the implantation of the device layer (2) a temperature processing step can be executed. This annealing step can be executed in a furnace or in a RTP (Rapid Thermal Processing) chamber.

The layered gate dielectric (10) and electrode material (2) is then patterned to yield the gate stack of the future individual nMOS transistors in the nMOS active area (8) and pMOS transistors in the pMOS active area (7) as shown in figure 2c. In case of nMOS devices the gate stack comprises the gate dielectric (10), the as-deposited part (6) of the electrode layer (2) and the doped part or disposable part (4) of the electrode layer. In case of the pMOS devices the gate stack doesn't comprise such disposable part.

The doped part of the nMOS gate stack is then removed e.g. by dry or wet etching as shown in figure 2d. Because all the nMOS gate stacks are exposed during the same nPLUS masking step to the same doping conditions the thickness d of the disposable part (4) will essentially be the same for all nMOS devices. The removal of the disposable part (4) is done selectively with respect to the undoped parts (6) of the gate electrode and to the gate dielectrice (10) of both the nMOS and pMOS devices and selectively with rtespect to the underlying substrate (1). Since the concentration of the dopant in the gate electrode material determines the etch rate during this removal step, the dose and energy of the implant step are used as tuning parameters for the rate of removal. K. Williams et al., compares in "Etch rates for micromaching processing" in Journal of microelectronical systems vol 5, no 4 of december 1996, the difference in etch rate of blanket undoped and n⁺ doped polysilicon. In US application 3,715,249 P. Panousis indicates the fact that highly doped polysilicon is unwantedly attacked by phosphoric acid and he seeks solutions to prevent such undesired etching by changing the etchant composition. About 50 to 200nm (4) of the gate electrode material is converted in the selected regions (3) and will be consumed during this removal step.

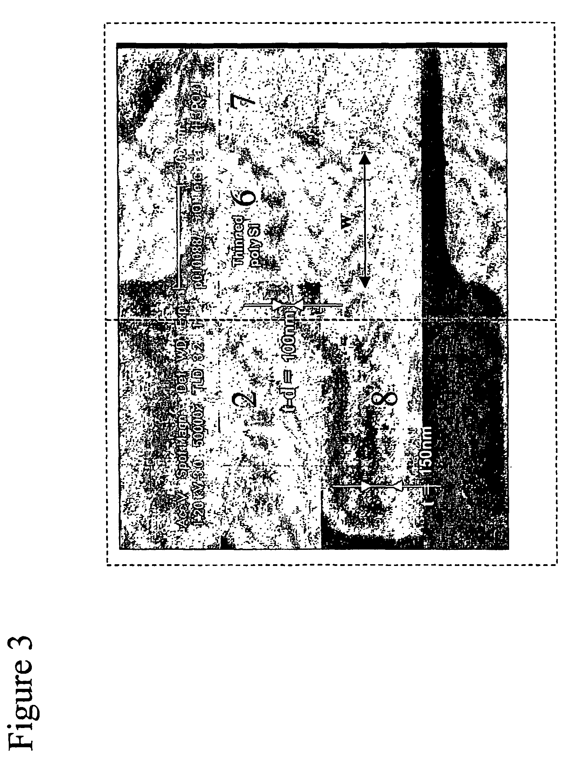

Figure 3 illustrates the process of locally thinning the gate electrode layer according to the present invention in case polysilicon is used as gate electrode material. On top of two areas (7,8), a polysilicon line with corresponding difference in thickness is present. The as-deposited thickness t (2) of 150nm is reduced in the right area (8) to t-d = 100nm (6). This process of locally thinning the polysilicon line is well controlled as is shown by this top view SEM picture. The thickness t-d of the thinned polysilicon line is very uniform and there is no impact on the line width or feature size w of the device. Because the removal of gate material occurs only from the top of the gate electrode and not from the undoped edges, the feature size w of the gate stack is preserved.

After removing the disposable part (4) of the gate electrode layer (2), the substrate (1), now comprising nMOS and pMOS devices with different gate electrode thicknesses, can be further processed using a CMOS process flow. The gate electrode of both nMOS and pMOS still is of the same electrode material. Formation of the junctions, spacers and silicide can be done. No problems with either spacer formation or the silicide forming process are expected. The difference in gate stack height, due to different polysilicon levels present, enables to vary the spacer thickness: thinner for lower gate and thicker for higher one. This variation in spacer thickness is beneficial from a CMOS architecture point of view. A thicker spacer in case of pMOS devices protects the pMOS transistor from extensive lateral diffusion of highly doped boron junctions (HDD) into the channel region underneath the gate stack. On the other hand, thinner spacers in case of nMOS devices enables to reduce the series resistance as long lowly doped extensions (LDD) are avoided. In our experiment the following spacer thickness were obtained:

| | |
|---|---|
| nMOS with polysilicon thickness t-d of 100nm: | spacer thickness of 45nm |
| pMOS with polysilicon thickness t of 150nm: | spacer thickness of 85nm |

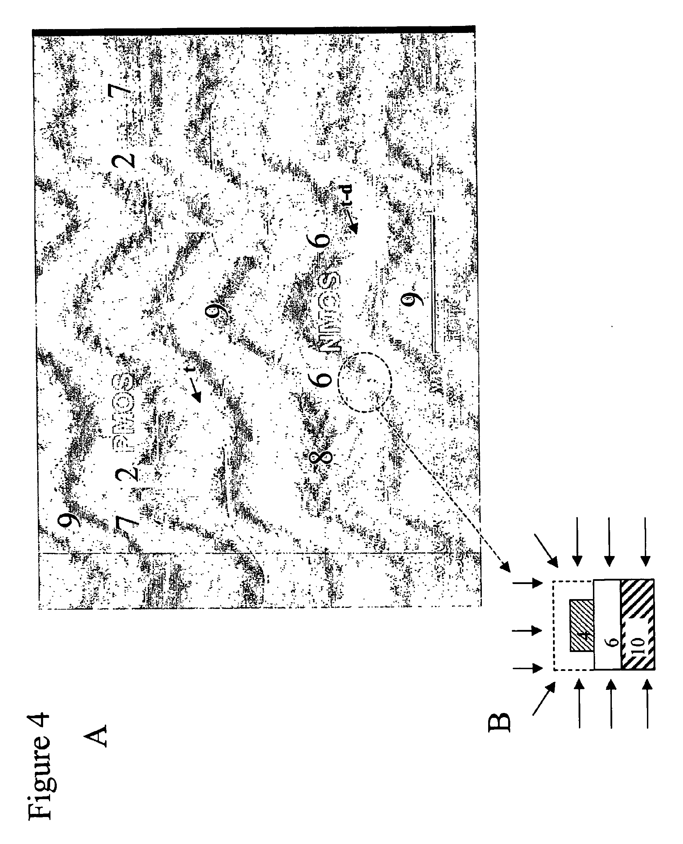

The differences in the spacer thickness in a CMOS circuit with dual thickness polysilicon gate can be seen in figure 4a. Two CMOS devices are formed: the pMOS devices are lying in isolated pMOS active areas (8) while the nMOS devices have nMOS active area (7) in common. Within the nMOS active area (7) the polysilicon line is thinned. Again the thickness uniformity and feature size is very well controlled. Figure 4b illustrates the effect of an isotropic process to remove the disposable parts. Although the gate stack comprising the gate dielectric (10), the unaffected part (6) of the gate electrode (2) and the disposable part (4) of the gate electrode (2), is exposed to the removing species (arrows) from the top and the side edges of the stack, only the disposable part (4) is being removed as indicated by the change in size of this disposable part (4) from the initial size (dashed outlined square) to the momentary size (hatched square). Also, no problems with forming contacts to the different poly levels of nMOS and pMOS devices are expected. During the step of etching contact holes in the premetal dielectric (PMD) covering the substrate (1), this difference in topologies deals with anyway, since the contacts to source and drain areas and to nMOS and pMOS gates are etched at the same time and all these surface are located at different levels.

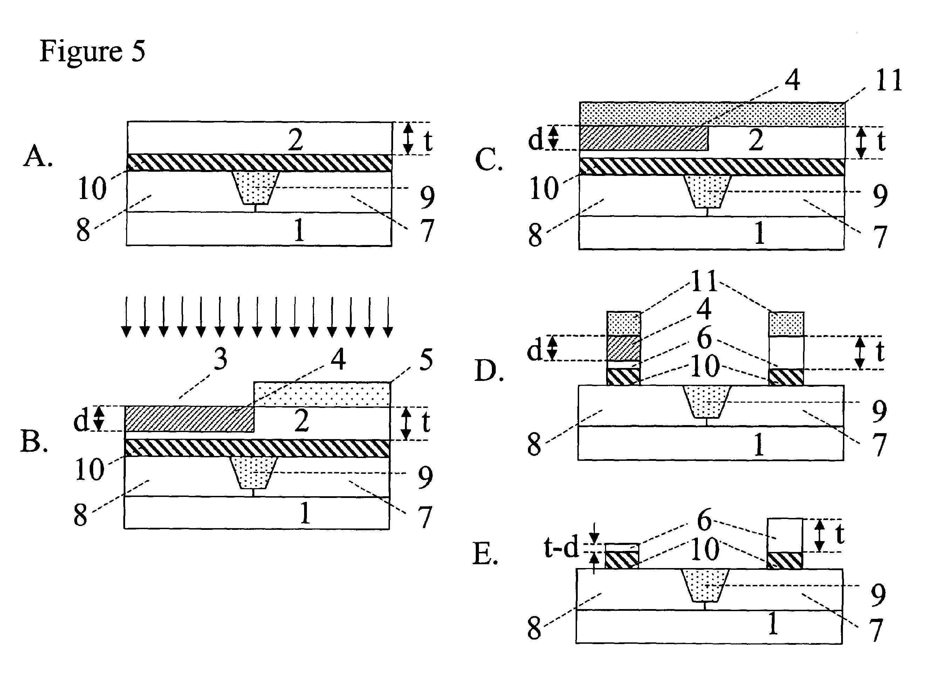

In a third, preferred, embodiment of the invention a method is disclosed to form a dual-thickness gate electrode in a submicron CMOS process as illustrated by figure 5a-e. A wafer such as an 8 inch silicon wafer (1) is processed including n- and p-type active area's (7,8) and field regions (9). A 5nm thick silicon dioxide gate dielectric layer is thermally grown. On top of this gate dielectric (10) 150nm of polycrystalline silicon (2) is deposited using a chemical vapour deposition (CVD) process (see figure 5a). This polysilicon layer serves as gate electrode layer. The standard lithographic step for the nMOS gate predoping is executed using the pwell mask to select the selected regions (3). A phosphorus dose of about 3e15/cm² is implanted with an energy of about 20keV in the selected regions (3) of the gate electrode (2) to form disposable parts (4) with a depth d of about 50nm (see figure 5b). As standard practice in submicron lithographic process applying 193 or 157nm lithographic technology an anti-reflective coating (ARC) is established on top of the gate electrode (2) (see figure 5c). This ARC layer (11) prevents unwanted reflection of the radiation incident at the interface of the resist (5) layer with the underlying gate electrode (2) during the step of exposing the resist layer. In this specific example a SiON layer of 50nm is used as ARC layer, although other materials are known and used by persons skilled in the art. The gate stack will be patterned as was discussed in the second embodiment as shown in figure 5d. The photosensitive layer (5) is removed leaving nMOS gate stacks comprising an ARC layer (11), a disposable part (4), an as-deposited part (6) and the gate dielectric (10) and pMOS gate stacks not comprising such a disposable part (4). The ARC layer (11) is removed using a standard phosphoric acid wet etching step. During this wet removal of the ARC also the higher doped part (4) of the polysilicon layer (2) is attacked. Thanks to the higher doping this part of the gate electrode becomes sensitive to the same etching species as was already being used for the removal of the ARC layer. Thanks to the high selectivity of the SiON and highly doped silicon etching with respect to undoped silicon, the removal process is well controlled. The etching process stops once the highly doped silicon part is removed resulting in dual gate CMOS devices as shown in figure 5e. The polysilicon thickness can thus be defined separately for nMOS and pMOS devices by defining the thickness t of the deposited polysilicon layer and doping conditions determining the doping depth d, prior to H3PO4 etching of both the ARC layer and the higher doped silicon parts.

Additional experiments have been performed according to this preferred embodiment. In a first series of tests 8-inch p-type silicon substrates were used. On top of these wafers a layer of 2nm Nitrogen Oxide (NO) dielectric was formed. On top of this gate dielectric 150nm of polycrsytalline silicon was deposited. This gate electrode material was doped using the splits listed in table 1. After partly doping the polysilicon layer the wafers were subject to an annealing step according to the splits in table 1. The SION antireflection layer was then deposited and the gate stack was patterned to form the individual transistors. After this patterning step, comprising the step of lithographic processing, etching and removal of the resist layer, the SiON layer remaining on top of the gate stack pattern is removed using phosphoric acid as indicated in table 1. The wafer is cleaned after this wet etching step by an HF-based cleaning solution.

**Table 1: overview of process splits in a first experiment according to a preferred embodiment**

| splits/wafernumber | **3** | **4** | **5** | **6** | **7** | **8** | **9** | **10** | **11** | **12** | **13** | **14** | **15** |
|---|---|---|---|---|---|---|---|---|---|---|---|---|---|
| **Gate predoping** | | | | | | | | | | | | | |
| As, 3e15, 40keV | x | | | | | | | | | | | | |
| As, 1e15, 40keV | | x | | | | | | | | | | | |
| B, 3e15, 5keV | | | x | | | | | | | | | | |
| BF2, 3e15, 6keV | | | | x | | | | | | | | | |
| P, 3e15, 20keV | | | | | x | | | x | x | x | x | x | x |
| P, 5e14, 20keV | | | | | | x | | | | | | | |
| P, 1e14, 20keV | | | | | | | x | | | | | | |

| **Annealing** | | | | | | | | | | | | | |
|---|---|---|---|---|---|---|---|---|---|---|---|---|---|
| 600C, 1min | | | | | | | | x | | | | | |
| 750C, 1min | | | | | | | | | x | | | | |
| 800C, 1 min | | | | | | | | | | x | | | |
| 850C, 1 min | | | | | | | | | | | x | | |
| 900C, 1 min | | | | | | | | | | | | x | |
| 950C, 30s | | | | | | | | | | | | | x |

| **SiON removal 10min** | | | | | | | | | | | | | |
|---|---|---|---|---|---|---|---|---|---|---|---|---|---|
| H3PO4 followed by | x | x | x | x | x | x | x | x | x | x | X | x | x |
| HF-based clean | | | | | | | | | | | | | |

In a second series of experiments 8-inch p-type silicon substrates were used. In this experiments a gate dielectric of 1.5nm NO was grown. A thinner gate dielectric was grown in order to investigate the selectivity of the wet etchant removing the doped part of the gate electrode towards the gate dielectric and the underlying substrate. Also a 150nm of polycrystalline silicon was grown to be used as gate electrode layer. For some wafers a CVD oxide, e.g. TEOS, was formed on top of this uniform polycryrstaline silicon layer as indicated in table 2. This layer will influence the implantation process as it forms an additional barrier to the incoming ions. The gate electrode layer is then doped with Phosphorus with an energy ranging from 20keV to 35keV and an implant dose ranging from 3e15 cm⁻² to 1e15 cm⁻², according to the splits listed in table 2. After the doping of the gate electrode layer, wether or not using an additional layer as stopping layer or implant barrier, some wafers were annealed with different annealing conditions. The TEOS layer is then removed by e.g. wet etchant such as an HF solution leaving the polysilicon layer essentially intact. The antireflective SiON layer is then deposited, followed by the patterning of the gate stacks. The protective resist layer on top of the gate stack is removed. The SiON layer is then removed by one of the two wet etchants, according to the splits listed in table 2. The removal of the sacrificial elements (4) is preferably done using a phosphoric solution in water with a concentration of between 83 to 87% by weigth of phosphoric acid. The operative temperature of the etching process is in between about 150 to 160 Celsius and preferably about 159 Celsius. The removal of the sacrificial elements (4) can also be done using a mixture of 95% sulfuric acid, 85% phosphoric acid and water in a ratio of 1/10/2 at an operative temperature of about 140 Celsius.

**Table 2: overview of process splits in a second experiment according to a preferred embodiment**

| **Splits / wafernumber** | 3 | 4 | 5 | 6 | 7 | 8 | 9 | 10 | 11 | 12 | 1 3 |
|---|---|---|---|---|---|---|---|---|---|---|---|
| **10nm TEOS deposition** | | x | x | | | | | x | X | | |

| **Gate predoping** | | | | | | | | | | | |
|---|---|---|---|---|---|---|---|---|---|---|---|
| (species, dose, energy) | | | | | | | | | | | |
| No doping | x | | | | | | | | | | |
| P, 3e15, 20keV | | x | x | x | x | x | x | | | | |
| P, 1e15, 35keV | | | | | | | | x | X | x | x |

| **Annealing** | | | | | | | | | | | |
|---|---|---|---|---|---|---|---|---|---|---|---|
| (temperature, time) | | | | | | | | | | | |
| 950C, 30s | | | | | | x | x | | | | |

| **SiON removal 10min** | | | | | | | | | | | |
|---|---|---|---|---|---|---|---|---|---|---|---|
| (etchant) | | | | | | | | | | | |
| H3PO4 followed by | x | x | | x | | x | | x | | x | |
| HF-based clean | | | | | | | | | | | |
| Mixture of H3PO4 and | | | x | | x | | x | | X | | x |
| H2P04 in water | | | | | | | | | | | |

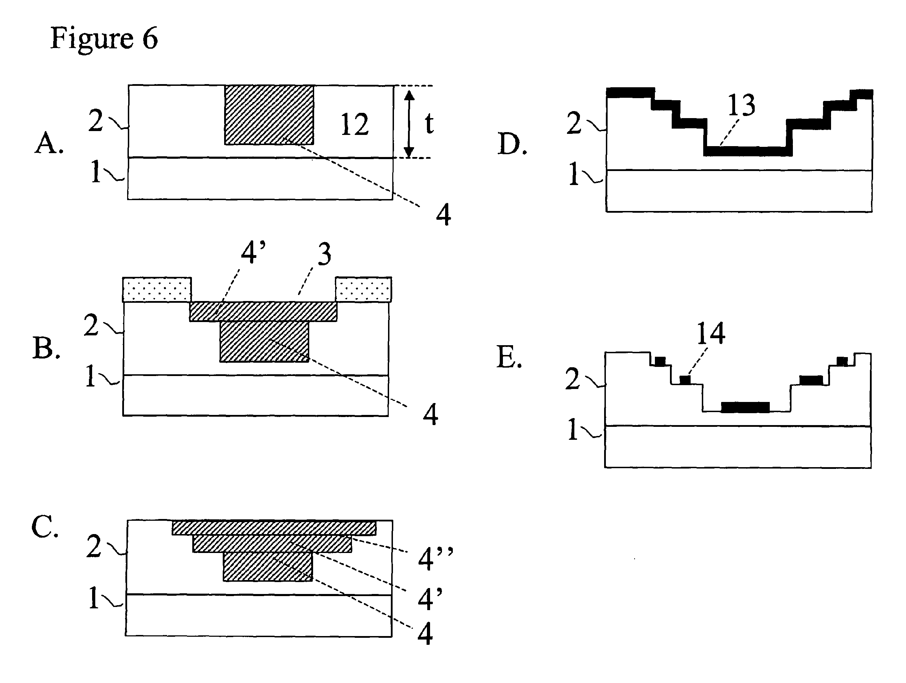

In a fourth embodiment of the invention the present invention is applied to the formation of Micro-electromechanical systems (MEMS) devices. Figure 6a shows the substrate (1) of a MEMS device on which a device layer (2) is deposited. This substrate can be a ceramic substrate, glass or a semiconductor substrate. The device or permanent layer (2) is partitioned in a disposable part (4) having predetermined dimensions and a non-disposable part (12). The partitioning is achieved using the methods disclosed in the previous embodiments (see e.g. figure 5b). Aligned to this first disposable element (4) new regions (3) can be selected and other disposable parts (4') are created as shown in figure 6b. In the figure 6c a device layer (2) is shown comprising a pyramidal shaped disposable part composed form 3 partially overlapping disposable parts (4, 4', 4"). After the removal of this pyramidal shaped disposable part a cavity is created in the device layer as shown in figure 6d. In this example the cavity is covered with a metal layer (13) yielding a concave shaped mirror. This metal layer (13) could also be patterned afterwards yielding e.g. a metal pattern (14) to be used as a contact, at each depth or level within the device layer 2, as defined by the depth of the corresponding disposable parts (4,4', 4").

## Claims

1. A method for creating topography in a device layer of an electronic component, or a device made using semiconductor processing techniques comprising the steps of:
providing a substrate (1),
forming a device layer (2) on said substrate (1),
creating a disposable part (4) in selected regions (3) of said device layer (2), the disposable part (4) being made from the same material as said device layer (2) and
being within the thickness of said device layer (2),
patterning said device layer (2), at least in said selected regions (3), and
selectively removing said disposable part (4) of said device layer (2),
**characterised in that** the step of selectively removing said disposable part (4) is performed after the pattering of the device layer (2).

2. A method as recited in claim 1 wherein the step of creating a disposable part (4) in selected regions (3) of said device layer (2), comprises the step of changing the removal properties of said device layer (2) up to a predetermined depth (d) within the device layer (2).

3. A method as recited in claim 2 wherein the step of changing the removal properties of said device layer (2) up to a predetermined depth (d) comprises the step of doping said selected regions (3) of said device layer (2) untill a predetermined depth (d).

4. A method as recited in claim 3 wherein said doping is done by ion implantation.

5. A method as recited in any of claims 1 to 4 wherein said substrate (1) is a semiconductor substrate.

6. A method as recited in any of claims 1 to 6 wherein said device layer (2) is a gate electrode layer.

7. A method as recited in claim 6 wherein said device layer (2) is of a semiconductor material.

8. A method as recited in claim 7 wherein said semiconductor material comprises silicon.

9. A method as recited in any of claims 1 to 8 further comprising the step of establishing an antireflective layer (11) on said device layer (2) prior to the step of patterning said device layer (2).

10. A method as recited in claim 9 wherein said antiflective layer (11) comprises at least one of Si, O and N.

11. A method as recited in claim 9 or 10 wherein during the step of selectively removing said disposable part (4) of said device layer (2), said patterned antireflective layer (11) is removed.

## Patentansprüche

1. Verfahren zum Erzeugen einer Topografie in einer Vorrichtungsschicht eines elektronischen Bauteils oder einer Vorrichtung, welche unter Verwendung von Halbleiter-Verarbeitungstechniken hergestellt wird, mit den folgenden Schritten:
Bereitstellen eines Substrates (1),
Bilden einer Vorrichtungsschicht (2) auf dem Substrat (1),
Erzeugen eines Opferteils (4) in ausgewählten Bereichen (3) der Vorrichtungsschicht (2), wobei das Opferteil (4) aus dem gleichen Material wie die Vorrichtungsschicht (2) besteht und sich innerhalb der Stärke der Vorrichtungsschicht (2) befindet,
Strukturierung der Vorrichtungsschicht (2) zumindest in den ausgewählten Bereichen (3), und
selektives Entfernen des Opferteils (4) der Vorrichtungsschicht (2),
**dadurch gekennzeichnet, dass** der Schritt zum selektiven Entfernen des Opferteils (4) nach dem Strukturieren der Vorrichtungsschicht (2) durchgeführt wird.

2. Verfahren nach Anspruch 1, wobei der Schritt zum Erzeugen eines Opferteils (4) in den ausgewählten Bereichen (3) der Vorrichtungsschicht (2) den Schritt zum Verändern der Entfernungseigenschaften der Vorrichtungsschicht (2) bis zu einer vorbestimmten Tiefe (d) innerhalb der Vorrichtungsschicht (2) aufweist.

3. Verfahren nach Anspruch 2, wobei der Schritt zum Verändern der Entfernungseigenschaften der Vorrichtungsschicht (2) bis zu einer vorbestimmten Tiefe (d) den Schritt zum Dotieren der ausgewählten Bereiche (3) der Vorrichtungsschicht (2) bis zu einer vorbestimmten Tiefe (d) aufweist.

4. Verfahren nach Anspruch 3, wobei das Dotieren durch Ionenimplantation erfolgt.

5. Verfahren nach einem der Ansprüche 1 bis 4, wobei das Substrat (1) ein Halbleitersubstrat ist.

6. Verfahren nach einem der Ansprüche 1 bis 6, wobei die Vorrichtungsschicht (2) eine Gate-Elektrodenschicht ist.

7. Verfahren nach Anspruch 6, wobei die Vorrichtungsschicht (2) aus einem Halbleitermaterial besteht.

8. Verfahren nach Anspruch 7, wobei das Halbleitermaterial Silizium aufweist.

9. Verfahren nach einem der Ansprüche 1 bis 8, welches zudem den Schritt zum Bilden einer antireflektierenden Schicht (11) auf der Vorrichtungsschicht (2) vor dem Schritt zum Strukturieren der Vorrichtungsschicht (2) aufweist.

10. Verfahren nach Anspruch 9, wobei die antireflektierende Schicht (11) Si, O und/oder N aufweist.

11. Verfahren nach Anspruch 9 oder 10, wobei während dem Schritt zum selektiven Entfernen des Opferteils (4) der Vorrichtungsschicht (2) die strukturierte antireflektierende Schicht (11) entfernt wird.

## Revendications

1. Procédé de création d'une topographie dans une couche formant dispositif d'un composant électronique, ou d'un dispositif obtenu par des procédés de fabrication de composants à semi-conducteur, comprenant les étapes de :
disposition d'un substrat (1) ;
formation d'une couche formant dispositif (2) sur ledit substrat (1) ;
création d'une partie éliminable (4) dans des zones sélectionnées (3) de ladite couche formant dispositif (2), la partie éliminable (4) étant faite du même matériau que celui de ladite couche formant dispositif (2) et étant située dans l'épaisseur de ladite couche formant dispositif (2) ;
formation de motifs sur ladite couche formant dispositif (2), au moins dans lesdites zones sélectionnées (3) ; et
élimination sélective de ladite partie éliminable (4) de ladite couche formant dispositif (2),
**caractérisé en ce que** l'étape d'élimination sélective de ladite partie éliminable (4) est exécutée après la formation de motifs sur la couche formant dispositif (2).

2. Procédé selon la revendication 1, dans lequel l'étape de création d'une partie éliminable (4) dans des zones sélectionnées (3) de ladite couche formant dispositif (2) comprend l'étape de modification des propriétés d'élimination de ladite couche formant dispositif (2) jusqu'à une profondeur prédéterminée (d) dans la couche formant dispositif (2).

3. Procédé selon la revendication 2, dans lequel l'étape de modification des propriétés d'élimination de ladite couche formant dispositif (2) jusqu'à une profondeur prédéterminée (d) comprend l'étape de dopage desdites zones sélectionnées (3) de ladite couche formant dispositif (2) jusqu'à une profondeur prédéterminée (d).

4. Procédé selon la revendication 3, dans lequel ledit dopage est effectué par implantation ionique.

5. Procédé selon l'une quelconque des revendications 1 à 4, dans lequel ledit substrat (1) est un substrat en semi-conducteur.

6. Procédé selon l'une quelconque des revendications 1 à 5, dans lequel ladite couche formant dispositif (2) est une couche formant électrode de grille.

7. Procédé selon la revendication 6, dans lequel ladite couche formant dispositif (2) consiste en un matériau semi-conducteur.

8. Procédé selon la revendication 7, dans lequel ledit matériau semi-conducteur comprend le silicium.

9. Procédé selon l'une quelconque des revendications 1 à 8, comprenant en outre l'étape de formation d'une couche antiréfléchissante (11) sur ladite couche formant dispositif (2) préalablement à l'étape de formation de motifs sur ladite couche formant dispositif (2).

10. Procédé selon la revendication 9, dans lequel ladite couche antiréfléchissante (11) comprend au moins l'un du Si, du O et du N.

11. Procédé selon la revendication 9 ou 10, dans lequel, pendant l'étape d'élimination sélective de ladite partie éliminable (4) de ladite couche formant dispositif (2), ladite couche antiréfléchissante (11), ayant reçu le motif, est éliminée.
